# EUROPEAN PATENT SPECIFICATION

(11) **EP 2 002 470 B1**
(45) Date of publication and mention of the grant of the patent: **09.03.2016**
(21) Application number: 07809002.4
(22) Date of filing: 03.04.2007
(51) Int. Cl.: H01L 29/66, H01L 29/786, H01L 27/105, H01L 27/108, H01L 29/423, H01L 29/78, H01L 29/06

(54) **Method fo growing nanofin transistors**
Methode zum Aufwachsen von Nanofin Transistoren
Méthode pour la croissance de transistors à nano-ailettes

(30) Priority: 04.04.2006 US 397527; 04.04.2006 US 397430; 04.04.2006 US 397358; 04.04.2006 US 397413; 04.04.2006 US 397406
(43) Date of publication of application: 17.12.2008
(73) Proprietor: Micron Technology, Inc., Boise, ID 83716-9632 (US)
(72) Inventor: FORBES, Leonard, Corvallis, OR 97330 (US)
(74) Representative: Maury, Richard Philip
(86) International application number: PCT/US2007/008084
(87) International publication number: WO 2007/136461

(56) References cited:
- WO-A-2005/079182
- DE-A1- 19 943 390
- US-A- 5 545 586
- US-A1- 2002 060 338
- US-A1- 2005 032 297
- US-A1- 2006 046 391
- US-B1- 6 747 313
- US-B1- 6 855 582

## Description

### Technical Field

This disclosure relates generally to semiconductor devices, and more particularly, to nanofin transistors.

### Background

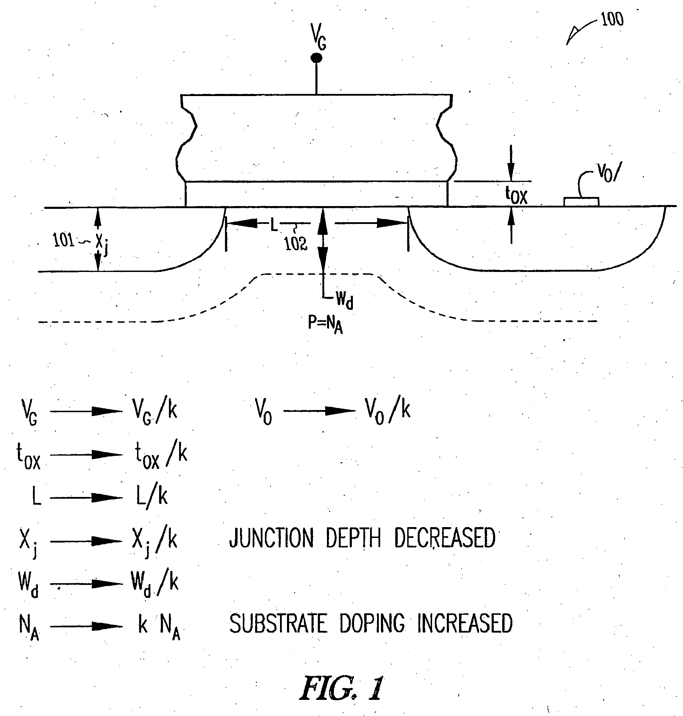

The semiconductor industry has a market driven need to reduce the size of devices, such as transistors, and increase the device density on a substrate. Some product goals include lower power consumption, higher performance, and smaller sizes. FIG. 1 illustrates general trends and relationships for a variety of device parameters with scaling by a factor k. The continuous scaling of MOSFET technology to the deep sub-micron region where channel lengths are less than 0.1 micron (100 nm or 1000 A) causes significant problems in the conventional transistor structures. For example, junction depths should be much less than the channel length. Thus, with reference to the transistor 100 illustrated in FIG. 1, the junctions depths 101 should be on the order of a few hundred Angstroms for channels lengths 102 that are approximately 1000 A long. Such shallow junctions are difficult to form by conventional implantation and diffusion techniques. Extremely high levels of channel doping are required to suppress short-channel effects such as drain induced barrier lowering, threshold voltage roll off, and sub-threshold conduction. Sub-threshold conduction is particularly problematic in DRAM technology as it reduces the charge storage retention time on the capacitor cells. These extremely high doping levels result in increased leakage and reduced carrier mobility. Thus, the expected improved performance attributed to a shorter channel is negated by the lower carrier mobility and higher leakage attributed to the higher doping.

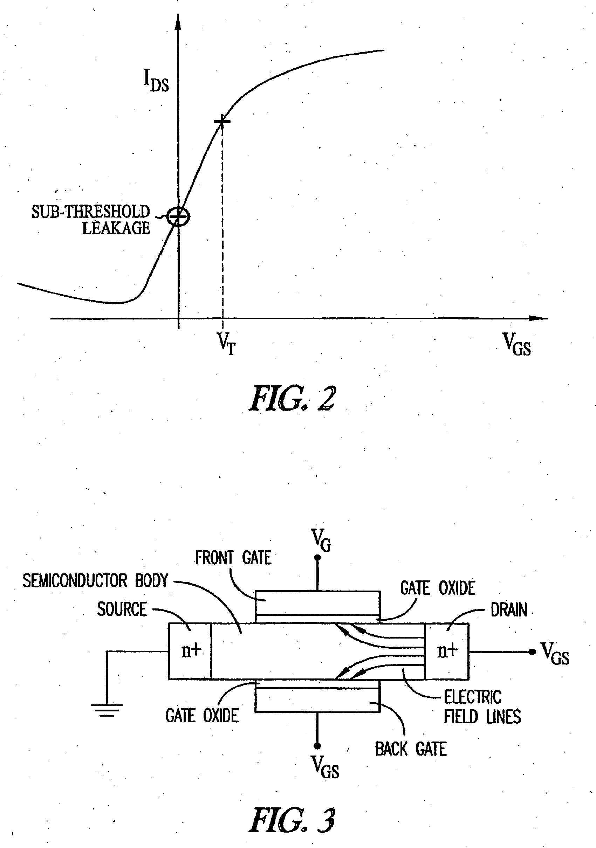

Leakage current is a significant issue in low voltage and lower power battery-operated CMOS circuits and systems, and particularly in DRAM circuits. The threshold voltage magnitudes are small to achieve significant overdrive and reasonable switching speeds. However, as illustrated in FIG. 2, the small threshold results in a relatively large sub-threshold leakage current.

Some proposed designs to address this problem use transistors with ultrathin bodies, or transistors where the surface space charge region scales as other transistor dimensions scale down. Dual-gated or double-gated transistor structures also have been proposed to scale down transistors. As commonly used in the industry, "dual-gate" refers to a transistor with a front gate and a back gate which can be driven with separate and independent voltages, and "double-gated" refers to structures where both gates are driven when the same potential. An example of a double-gated device structure is the FinFET. "TriGate" structures and surrounding gate structures have also been proposed. In the "TriGate" structure, the gate is on three sides of the channel. In the surrounding gate structure, the gate surrounds or encircles the transistor channel. The surrounding gate structure provides desirable control over the transistor channel, but the structure has been difficult to realize in practice.

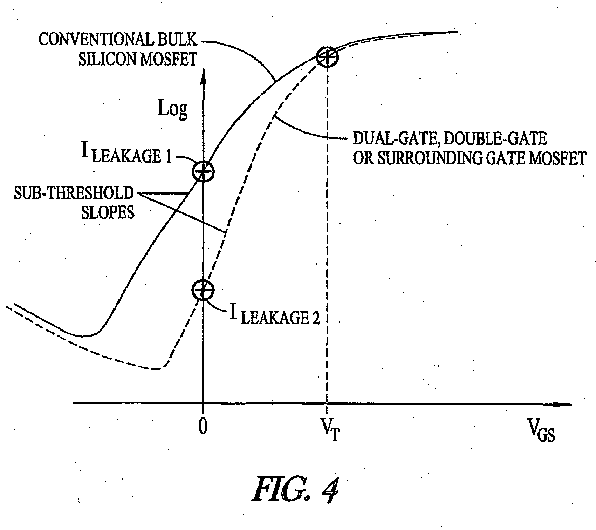

FIG. 3 illustrates a dual-gated MOSFET with a drain, a source, and front and back gates separated from a semiconductor body by gate insulators, and also illustrates an electric field generated by the drain. Some characteristics of the dual-gated and/or double-gated MOSFET are better than the conventional bulk silicon MOSFETs, because compared to a single gate, the two gates better screen the electric field generated by the drain electrode from the source-end of the channel. The surrounding gate further screens the electric field generated by the drain electrode from the source. Thus, sub-threshold leakage current characteristics are improved, because the sub-threshold current is reduced more quickly as the gate voltage is reduced when the dual-gate and/or double gate MOSFET turns off. FIG. 4 generally illustrates the improved sub-threshold characteristics of dual gate, double-gate, or surrounding gates MOSFETs in comparison to the sub-threshold characteristics of conventional bulk silicon MOSFETs.

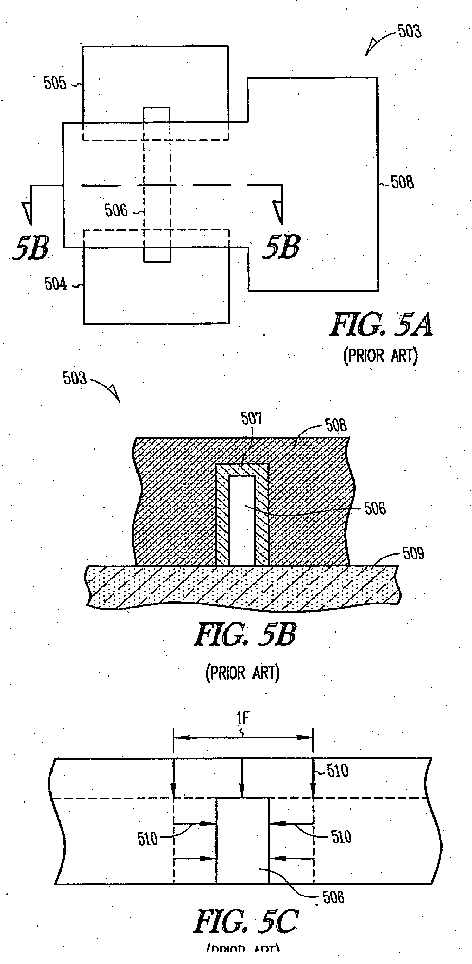

FIGS. 5A-C illustrate a conventional FinFET. FIG. 5A illustrates a top view of the FinFET and FIG. 5B illustrates an end view of the FinFET along line 5B-5B. The illustrated FinFET 503 includes a first source/drain region 504, a second source drain region 505, and a silicon fin 506 extending between the first and second source/drain regions. The silicon fin functions as a transistor body, where the channel between the first and second source/drain regions is horizontal. A gate insulator 507, such as silicon oxide, is formed over the fin, and a gate 508 is formed over the fin after the oxide is formed thereon. The fin of the illustrated conventional FinFET is formed over buried oxide 509. FIG. 5C illustrates a conventional etch technique for fabricating the fin for the FINFET. As illustrated in FIG. 5C, the fin width is defined by photolithography or e-beam lithography and etch. Thus, the fin width is initially a minimum feature size (1F). The width of the fin is subsequently reduced by oxidation or etch, as illustrated by arrows 510.

US 2002/060338 discloses a method of forming a vertical transistor using an amorphous side walls spacer which is crystallised by solid state crystallisation as a seed.

US 5,545,586 discloses a method for forming a transistor, comprising forming a transistor body, including forming a sidewall spacer using a semiconductor material on a crystalline substrate, the side wall spacer having a cross-sectional thickness in at least one direction less than a minimum feature size; and forming a crystalline fin from the side wall spacer, wherein forming the crystalline fin includes performing a solid phase epitaxy, SPE process to crystallize the semiconductor material using the crystalline substrate to seed the crystalline growth, the transistor body being formed in the crystalline fin between a first source/drain region and a second source/drain region; forming a surrounding gate insulator around the crystalline fin; and forming a surrounding gate around and separated from the semiconductor fin by the surrounding gate insulator.

The invention is in the method of Claim 1.

### Summary

Aspects of the present subject matter grow ultrathin fins of semiconductor (e.g. silicon) from amorphous silicon semiconductor using solid phase epitaxy (SPE) on a crystalline silicon substrate. The SPE process recrystallizes the amorphous semiconductor, using the crystalline substrate to seed the crystalline growth. The amorphous nanofins are formed with dimensions smaller than lithographic dimensions by a sidewall spacer technique. The nanofins are used as the body regions of CMOS transistors where both the thickness of the body of the transistor and channel length have dimensions smaller than lithographic dimensions. For example, some embodiments provide ultrathin nanofins with a thickness on the order of 20 nm to 50 nm.

One aspect of the present subject matter relates to a method for forming transistor. According to an embodiment, a fin of amorphous silicon semiconductor material is formed on a crystalline silicon substrate, and a solid phase epitaxy (SPE) process is performed to crystallize the amorphous semiconductor material using the crystalline substrate to seed the crystalline growth. The fin has a cross-sectional thickness in at least one direction less than a minimum feature size. The transistor body is formed in the crystallized semiconductor pillar between a first source/drain region and a second source/drain region. A surrounding gate insulator is formed around the semiconductor pillar, and a surrounding gate is formed around and separated from the semiconductor pillar by the surrounding gate insulator.

In an embodiment for forming a transistor, a silicon nitride layer is formed on a silicon wafer, and a hole is etched in the silicon nitride. The hole extends through the silicon nitride layer to the silicon wafer and is defined by the sides of the silicon nitride layer. Amorphous silicon oxide sidewall spacers are formed on the sides of the silicon nitride that define the hole. The silicon nitride layer is removed, leaving the amorphous silicon oxide sidewall spacers on the silicon wafer. The sidewall spacers are crystallized. The sidewall spacers are masked and etched to form at least one silicon fin from the sidewall spacers. The silicon fin is positioned over a doped region to function as a first source/drain region for the transistor. A surrounding gate insulator is formed around the silicon fin, and a surrounding gate is formed around and separated from the silicon fin by the surrounding gate insulator. A second source/drain region is formed in a top portion of the silicon fin.

A transistor formed by a process of the invention includes a crystalline substrate, a crystalline semiconductor fin on the substrate, a gate insulator formed around the fin, and a surrounding gate formed around and separated form the fin by the gate insulator. The fin has a cross-sectional dimension that is less than a minimum feature size. The fin provides a vertically-oriented channel between a lower source/drain region and an upper source/drain region.

These and other aspects, embodiments, advantages, and features will become apparent from the following description of the present subject matter and the referenced drawings.

### Brief Description of the Drawings

FIG. 1 illustrates general trends and relationships for a variety of device parameters with scaling by a factor k.
FIG. 2 illustrates sub-threshold leakage in a conventional silicon MOSFET.
FIG. 3 illustrates a dual-gated MOSFET with a drain, a source, front and back gates separated from a semiconductor body by gate insulators, and an electric field generated by the drain.
FIG. 4 generally illustrates the improved sub-threshold characteristics of dual gate, double-gate, and surrounding gate MOSFETs in comparison to the sub-threshold characteristics of conventional bulk silicon MOSFETs.
FIGS. 5A-C illustrate a conventional FinFET.
FIGS. 6A-6L illustrate a process for forming a nanofin transistor, according to various embodiments of the present subject matter.
FIG. 7 illustrates a top view of a layout of nanofins for an array of nanofin transistors, according to various embodiments of the present subject matter.
FIG. 8 illustrates a process to fabricate a nanofin transistor, according to various embodiments of the present subject matter.
FIG. 9 illustrates a process to form amorphous semiconductor fins, according to various embodiments of the present subject matter.
FIG. 10 is a simplified block diagram of a high-level organization of various embodiments of a memory device according to various embodiments of the present subject matter.
FIG. 11 illustrates a diagram for an electronic system having nanofin transistors.
FIG. 12 depicts a diagram of an embodiment of a system having a controller and a memory.

### Detailed Description

The following detailed description refers to the accompanying drawings which show, by way of illustration, specific aspects and embodiments in which the present subject matter may be practiced. These embodiments are described in sufficient detail to enable those skilled in the art to practice the present subject matter. The various embodiments of the present subject matter are not necessarily mutually exclusive as aspects of one embodiment can be combined with aspects of another embodiment. Other embodiments may be utilized and structural, logical, and electrical changes may be made without departing from the scope of the present subject matter. In the following description, the terms "wafer" and "substrate" are interchangeably used to refer generally to any structure on which integrated circuits are formed, and also to such structures during various stages of integrated circuit fabrication. Both terms include doped and undoped semiconductors, epitaxial layers of a semiconductor on a supporting semiconductor or insulating material, combinations of such layers, as well as other such structures that are known in the art. The term "horizontal" as used in this application is defined as a plane parallel to the conventional plane or surface of a wafer or substrate, regardless of the orientation of the wafer or substrate. The term "vertical" refers to a direction perpendicular to the horizontal as defined above. Prepositions, such as "on", "side", "higher", "lower", "over" and "under" are defined with respect to the conventional plane or surface being on the top surface of the wafer or substrate, regardless of the orientation of the wafer or substrate. The following detailed description is, therefore, not to be taken in a limiting sense, and the scope of the present invention is defined only by the appended claims, along with the full scope of equivalents to which such claims are entitled.

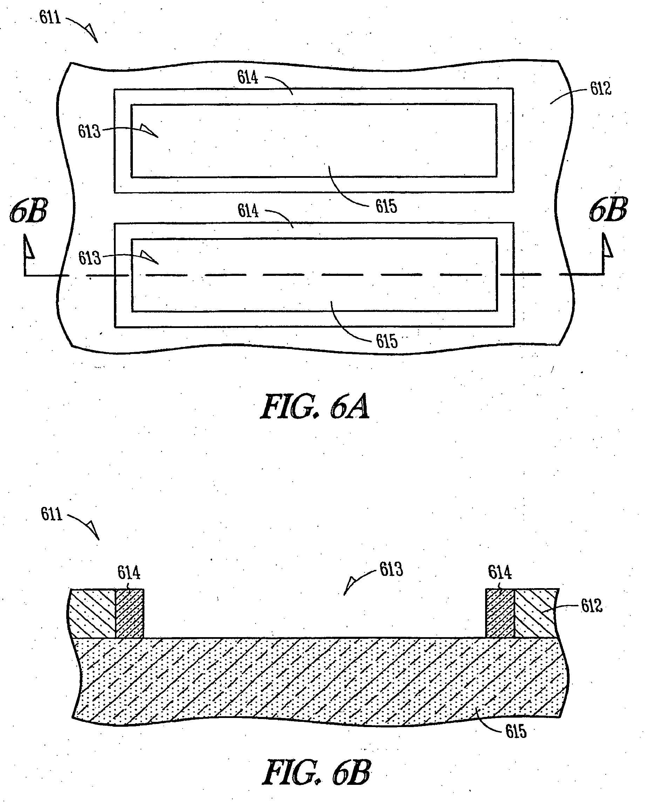

Disclosed herein are nanofin transistors, and a fabrication technique in which vertical amorphous silicon nanofins are recrystallized on a substrate to make single crystalline silicon nanofin transistors. Aspects of the present subject matter provide nanofin transistors with vertical channels, where there is a first source/drain region at the bottom of the fin and a second source/drain region at the top of the fin. FIGS. 6A-6L illustrate a process for forming a nanofin transistor, according to various embodiments of the present subject matter.

FIGS. 6A and 6B illustrate a top view and a cross-section view along 6B-6B, respectively, of a semiconductor structure 611 with a silicon nitride layer 612, holes 613 in the silicon nitride layer, and sidewall spacers 614 of amorphous silicon along the walls of the holes. The holes are etched in the silicon nitride layer, and amorphous silicon deposited and directionally etched to leave only on the sidewalls. The holes 613 are etched through the silicon nitride layer 612 to a silicon wafer or substrate 615.

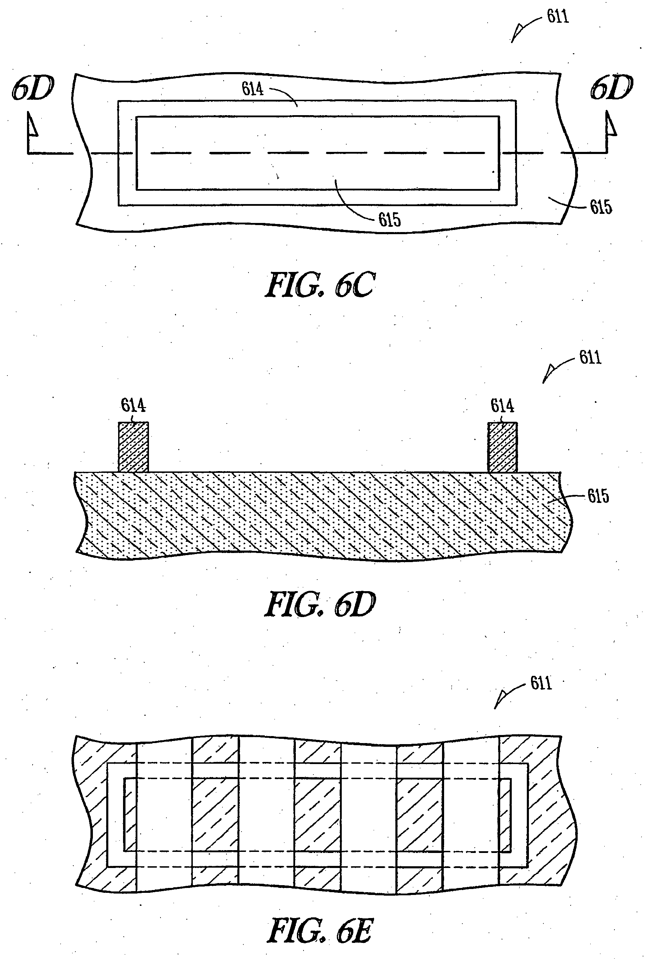

FIGS. 6C and 6D illustrate a top view and a cross-section view along line 6D-6D, respectively, of the structure after the silicon nitride layer is removed. As illustrated, after the silicon nitride layer is removed, the sidewalls 614 are left as standing narrow regions of amorphous silicon. The resulting patterns of standing silicon can be referred to as "racetrack" patterns, as they have a generally elongated rectangular shape. The width of the lines is determined by the thickness of the amorphous silicon rather than masking and lithography. For example, the thickness of the amorphous silicon may be on the order of 20 nm to 50 nm, according to various embodiments. A solid phase epitaxial (SPE) growth process is used to recrystallize the standing narrow regions of amorphous silicon. The SPE growth process includes annealing, or heat treating, the structure to cause the amorphous silicon to crystallize, beginning at the interface with the silicon substrate 615 which functions as a seed for crystalline growth up through the remaining portions of the standing narrow regions of silicon.

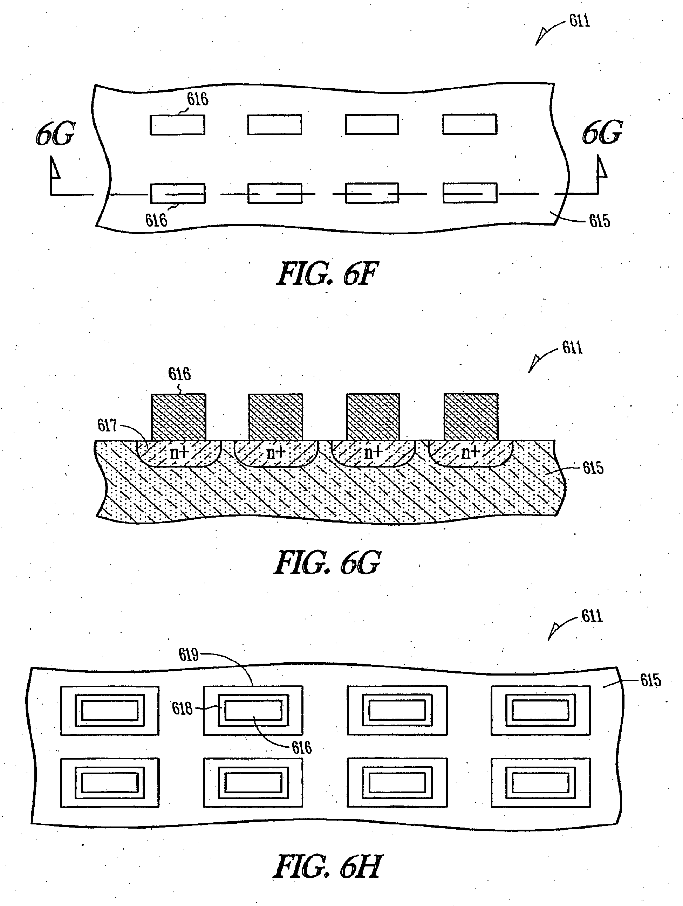

FIG. 6E illustrates a top view of the structure 611, after a mask layer has been applied. The shaded areas are etched, leaving free-standing fins formed of crystalline silicons FIGS. 6F and 6G illustrate a top view and a cross-section view along line 6G-6G, respectively, of the pattern of free-standing fins 616. A buried doped region 617 functions as a first source/drain region. According to various embodiments, the buried doped region can be patterned to form a conductive line either the row or column direction of the array of fins.

FIG. 6H illustrates a top view of the structure, where the fins have been surrounded by a gate insulator 618 and a gate 619. The gate insulator can be deposited or otherwise formed in various ways. For example, a silicon oxide can be formed on the silicon fin by a thermal oxidation process. The gate can be any gate material, such as polysilicon or metal. The gate material is deposited and directionally etched to leave the gate material only on the sidewalls of the fin structure with the gate insulator. The wiring can be oriented in either the "x-direction" or "y-direction."

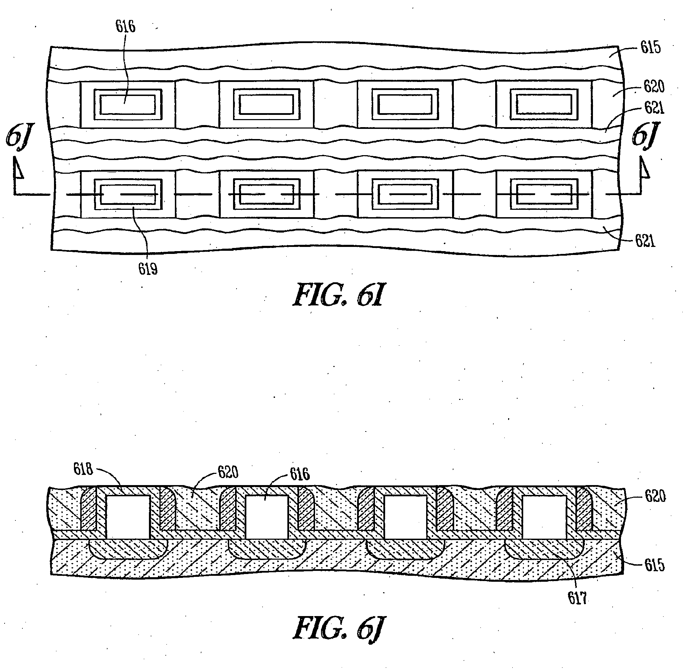

FIGS. 6I and 6J illustrate a top view and a cross-section view along line 6J-6J, respectively, of the structure illustrated in FIG. 6H after the structure is backfilled with an insulator 620 and gate wiring 621 is formed in an "x-direction" along the long sides of the fins. Various embodiments backfill the structure with silicon oxide. Trenches are formed in the backfilled insulator to pass along a side of the fins, and gate lines are formed in the trenches. In various embodiments, one gate line passes along one side of the fins, in contact with the surrounding gate of the fin structure. Some embodiments provide a first gate line on a first side of the fin and a second gate line on a second side of the fin. The gate wiring material, such as polysilicon or metal, can be deposited and directionally etched to leave on the sidewalls only. The gate wiring material appropriately contacts the surrounding gates for the fins. In various embodiments, the gate material and gate wiring material are etched to recess the gate and gate wiring below the tops of the fins. The whole structure can be backfilled with an insulator, such as silicon oxide, and planarized to leave only oxide on the surface. The top of the pillars or fins can be exposed by an etch. A second source/drain region 622 can be implanted in a top portion of the fins, and metal contacts 623 to the drain regions can be made by conventional techniques. The metal wiring can run, for example, in the "x-direction" and the buried source wiring run perpendicular, in the plane of the paper in the illustration.

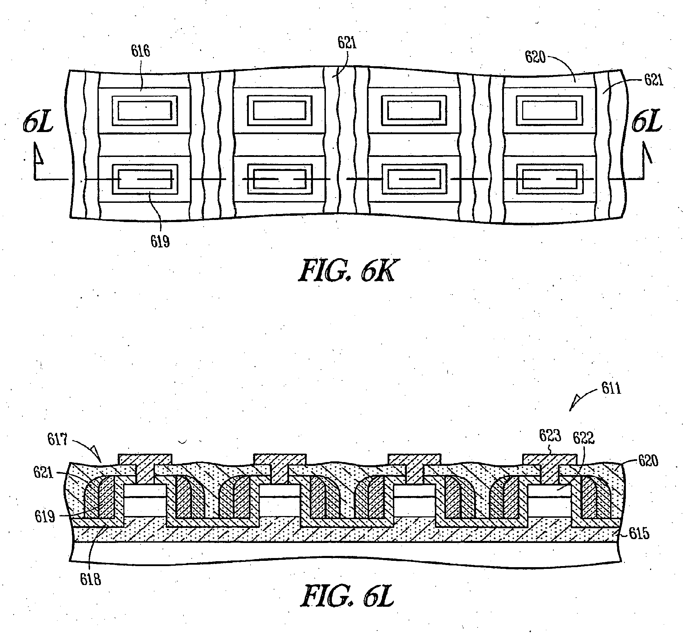

FIGS. 6K and 6L illustrate a top view and a cross-section view along line 6L-6L, respectively, of the structure after the structure is backfilled with an insulator and gate wiring is formed in an "y-direction" along the short sides of the fins. Trenches are opened up along the side of the fins in the "y-direction." Gate wiring material 621, such as polysilicon or metal, can be deposited and directionally etched to leave on the sidewalls only and contacting the gates on the fins. In various embodiments, the gate material and gate wiring material are etched to recess the gate and gate wiring below the tops of the fins. The whole structure can be backfilled with an insulator 620, such as silicon oxide, and planarized to leave only the backfill insulator on the surface. Contact openings and drain doping regions 622 can then be etched to the top of the pillars and drain regions implanted and metal contacts to the drain regions made by conventional techniques. The metal wiring can run, for example, perpendicular to the plane of the paper in the illustration and the buried source wiring runs in the "x-direction." The buried source/drains are patterned and implanted before deposition of the amorphous silicon. FIG. 6L gives an illustration of one of the completed fin structures with drain/source regions, recessed gates, and source/drain region wiring. These nanofin FET's can have a large W/L ratio and are able to conduct more current than nanowire FET's.

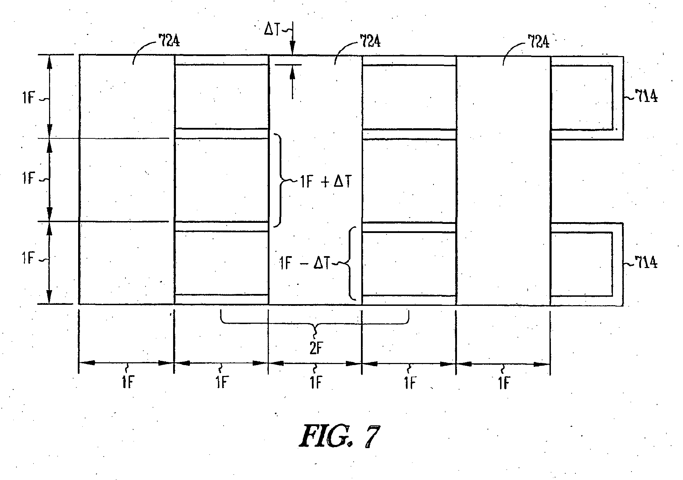

FIG. 7 illustrates a top view of a layout of nanofins for an array of nanofin transistors, according to various embodiments. The figure illustrates two "racetracks" of sidewall spacers 714, and further illustrates the portions of the sidewall spacers removed by an etch. The holes used to form the sidewall spacer tracks were formed with a minimum feature size (1F). The mask strips 724 have a width of a minimum feature size (1F) and are separated by a minimum feature size (1F). In the illustrated layout, the columns of the nanofins have an approximately 2F center-to-center spacing, and the rows of the nanofins have an approximately 1F center-to-center spacing. Also, as illustrated in FIG. 7, since the nanofins are formed from sidewall spacers on the walls of the holes, the center-to-center spacing between first and second rows will be slightly less than 1F by an amount corresponding to the thickness of the nanofins (1F - ΔT), and the center-to-center spacing between second and third rows will be slightly more than 1F size by an amount corresponding to the thickness of the nanofins (1F + ΔT). In general, the center-to-center spacing between first and second rows will be slightly less than a feature size interval (NF) by an amount corresponding to the thickness of the nanofins (NF - ΔT), and the center-to-center spacing between second and third rows will be slightly more than a feature size interval (NF) by an amount corresponding to the thickness of the nanofins (NF + ΔT).

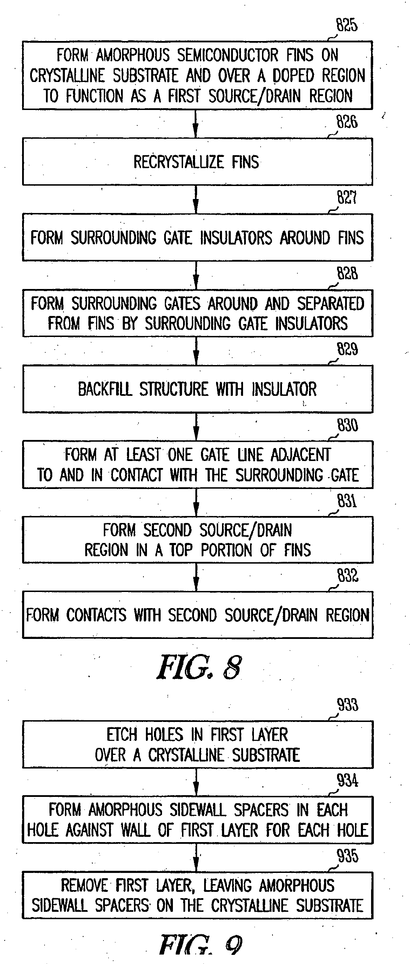

FIG. 8 illustrates a process to fabricate a nanofin transistor, according to various embodiments of the present subject matter. At 825, amorphous semiconductor fins are formed on a crystalline substrate and over a doped region that is to function as a first source/drain region. In some embodiments, the substrate is doped and diffused after the fins are formed. The fins are thin such that the dopant is able to diffuse under and into a bottom portion of the fin. The fins are crystallized at 826. A solid phase epitaxial (SPE) process is used, in which the structure is annealed and the crystalline substrate seeds crystalline growth in the fins. At 827, surrounding gate insulators are formed around the fins; and at 828, surrounding gates are formed around and separated from the fins by surrounding the gate insulators. The resulting structure is backfilled with an insulator at 829. Trenches are etched and gate line(s) are formed adjacent to and in contact with the surrounding gate, as illustrated at 830. At 831, a second source/drain region is formed in a top portion of the fins, and contacts for the second source/drain regions are formed at 832.

FIG. 9 illustrates a process to form amorphous semiconductor fins, such as illustrated at 825 in FIG. 8, according to various embodiments of the present subject matter. At 933, holes are etched in a first layer over a crystalline substrate. At 934, amorphous sidewall spacers are formed in each hole against the wall of the first layer for each hole. The first layer is removed at 935, which leaves the amorphous semiconductor fins on the crystalline substrate.

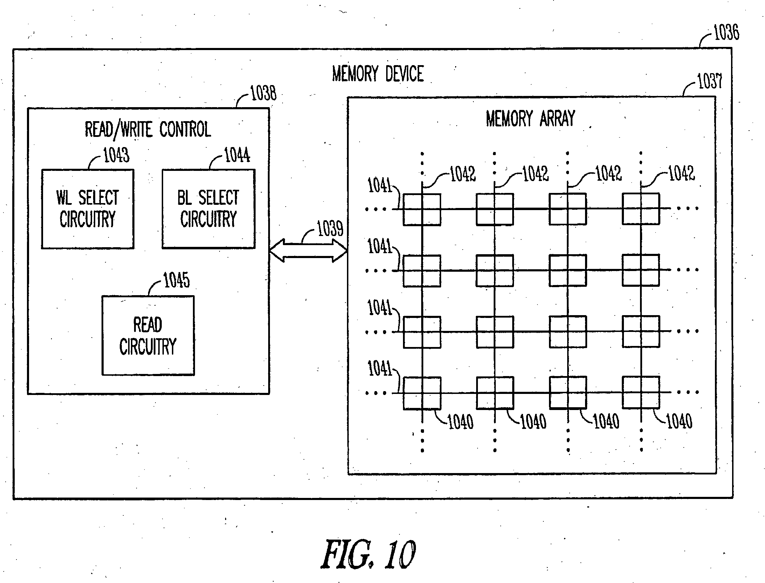

FIG. 10 is a simplified block diagram of a high-level organization of various embodiments of a memory device according to various embodiments of the present subject matter. The illustrated memory device 1036 includes a memory array 1037 and read/write control circuitry 1038 to perform operations on the memory array via communication line(s) or channel(s) 1039. The illustrated memory device 1036 may be a memory card or a memory module such as a single inline memory module (SIMM) and dual inline memory module (DIMM). One of ordinary skill in the art will understand, upon reading and comprehending this disclosure, that semiconductor components in the memory array and / or the control circuitry can include nanofin transistors, as described above. The structure and fabrication methods for these devices have been described above.

The memory array 1037 includes a number of memory cells 1040. The memory cells in the array are arranged in rows and columns. In various embodiments, word lines 1041 connect the memory cells in the rows, and bit lines 1042 connect the memory cells in the columns. The read/write control circuitry 1038 includes word line select circuitry 1043 which functions to select a desired row, bit line select circuitry 1044 which functions to select a desired column, and read circuitry 1045 which functions to detect a memory state for a selected memory cell in the memory array 1037.

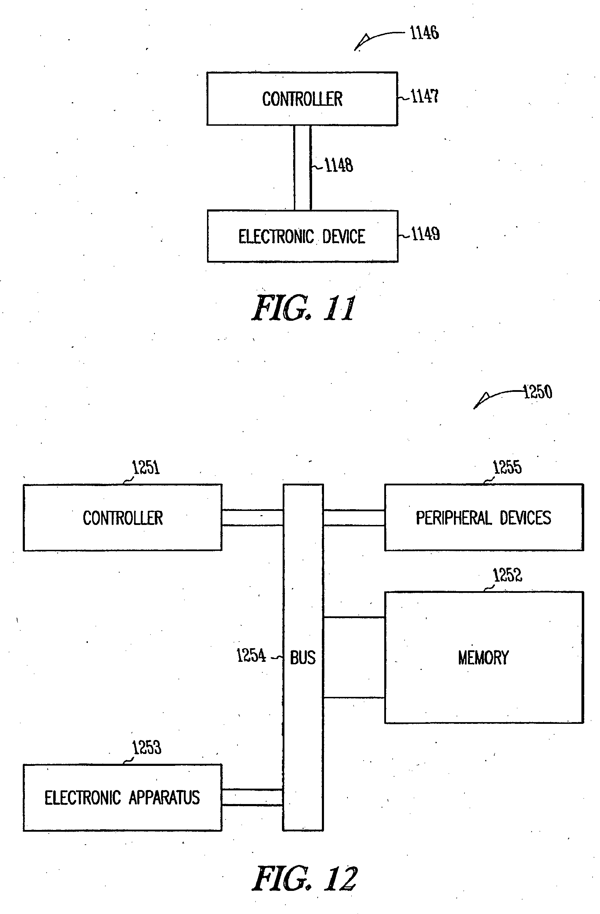

FIG. 11 illustrates a diagram for an electronic system 1146 having one or more nanofin transistors, according to various embodiments. Electronic system 1146 includes a controller 1147, a bus 1148, and an electronic device 1149, where the bus provides communication channels between the controller and the electronic device. In various embodiments, the controller and/or electronic device include nanofin transistors as previously discussed herein. The illustrated electronic system 1146 may include, but is not limited to, information handling devices, wireless systems, telecommunication systems, fiber optic systems, electro-optic systems, and computers.

FIG. 12 depicts a diagram of an embodiment of a system 1250 having a controller 1251 and a memory 1252. The controller 1251 and/or memory 1252 may include nanofin transistors according to various embodiments. The illustrated system 1250 also includes an electronic apparatus 1253 and a bus 1254 to provide communication channel(s) between the controller and the electronic apparatus, and between the controller and the memory. The bus may include an address, a data bus, and a control bus, each independently configured; or may use common communication channels to provide address, data, and/or control, the use of which is regulated by the controller. In an embodiment, the electronic apparatus 1253 may be additional memory configured similar to memory 1252. An embodiment may include a peripheral device or devices 1255 coupled to the bus 1254. Peripheral devices may include displays, additional storage memory, or other control devices that may operate in conjunction with the controller and/or the memory. In an embodiment, the controller is a processor. Any of the controller 1251, the memory 1252, the electronic apparatus 1253, and the peripheral devices 1255 may include nanofin transistors according to various embodiments. The system 1250 may include, but is not limited to, information handling devices, telecommunication systems, and computers. Applications containing nanofin transistors, as described in this disclosure, include electronic systems for use in memory modules, device drivers, power modules, communication modems, processor modules, and application-specific modules, and may include multilayer, multichip modules. Such circuitry can further be a subcomponent of a variety of electronic systems, such as a clock, a television, a cell phone, a personal computer, an automobile, an industrial control system, an aircraft, and others.

The memory may be realized as a memory device containing nanofin transistors according to various embodiments. It will be understood that embodiments are equally applicable to any size and type of memory circuit and are not intended to be limited to a particular type of memory device. Memory types include a DRAM, SRAM (Static Random Access Memory) or Flash memories. Additionally, the DRAM could be a synchronous DRAM commonly referred to as SGRAM (Synchronous Graphics Random Access Memory), SDRAM (Synchronous Dynamic Random Access Memory), SDRAM II, and DDR SDRAM (Double Data Rate SDRAM). Various emerging memory technologies are capable of using nanofin transistors.

This disclosure includes several processes, circuit diagrams, and cell structures. The present subject matter is not limited to a particular process order or logical arrangement. Although specific embodiments have been illustrated and described herein, it will be appreciated by those of ordinary skill in the art that any arrangement which is calculated to achieve the same purpose may be substituted for the specific embodiments shown. This application is intended to cover adaptations or variations of the present subject matter. It is to be understood that the above description is intended to be illustrative, and not restrictive. Combinations of the above embodiments, and other embodiments, will be apparent to those of skill in the art upon reviewing and understanding the above description. The scope of the present subject matter should be determined with reference to the appended claims; along with the full scope of equivalents to which such claims are entitled.

## Claims

1. A method for forming transistors, comprising:
forming a transistor body, including:
etching, by a lithographic process, a hole (613) in a silicon nitride layer (612) formed on a crystalline silicon substrate (615);
depositing amorphous silicon and directionally etching it, so as to only leave amorphous silicon (614) on the sidewall of the hole;
removing the silicon nitride layer (612) to leave only the amorphous silicon (614) on the crystalline silicon substrate;
performing a solid phase epitaxy, SPE process to crystallize the amorphous silicon into a crystalline silicon wall using the crystalline silicon substrate (615) to seed the crystalline growth,
etching away portions of the crystalline silicon wall to leave crystalline fins (616);
each of the transistor bodies being formed in the respective crystalline fin between a first source/drain region and a second source/drain region;
forming a surrounding gate insulator around each crystalline fin; and
forming a surrounding gate around and separated from each crystalline fin by the surrounding gate insulator.

2. The method according to claim 1, further comprising recessing the surrounding gate such that the surrounding gate has a height less than a height of each crystalline fin.

3. The method according to claim 1 or claim 2, further comprising forming the first source/drain region at a first end of the crystalline fin and forming the second source/drain region at a second end of each crystalline fin.

4. The method according to claim 1 or claim 2, wherein the first source/drain region is beneath the second source/drain region, and a channel region is vertically oriented between the first and second source/drain regions.

5. The method according to any one of claims 1 to 4, further comprising forming at least one gate line adjacent to and in contact with the surrounding gates for at least two transistors.

6. The method according to claim 5, wherein forming at least one gate line includes forming two gate lines adjacent to and in contact with the surrounding gate, the two gate lines being on opposing crystalline fins.

## Patentansprüche

1. Verfahren zum Ausbilden von Transistoren, umfassend:
Ausbilden eines Transistorkörpers, einschließlich:
durch einen lithografischen Prozess erfolgendes Ätzen eines Lochs (613) in eine Siliziumnitridschicht (612), die auf einem Substrat (615) aus kristallinem Silizium ausgebildet ist;
Abscheiden von amorphem Silizium und gerichtetes Ätzen desselben, um dadurch nur auf der Seitenwand des Lochs amorphes Silizium (614) übrig zu lassen;
Entfernen der Siliziumnitridschicht (612), um nur das amorphe Silizium (614) auf dem Substrat aus kristallinem Silizium übrig zu lassen;
Durchführen eines Festphasenepitaxie-(SPE-)Prozesses, um das amorphe Silizium zu einer Wand aus kristallinem Silizium zu kristallisieren, wobei das Substrat (615) aus kristallinem Silizium verwendet wird, um das Kristallwachstum anzuimpfen,
Fortätzen von Abschnitten der Wand aus kristallinem Silizium, um kristalline Rippen (616) übrig zu lassen;
wobei jeder der Transistorkörper in der jeweiligen kristallinen Rippe zwischen einem ersten Source/Drain-Bereich und einem zweiten Source/Drain-Bereich ausgebildet wird;
Ausbilden eines umgebenden Gate-Isolators rings um jede kristalline Rippe; und
Ausbilden eines umgebenden Gates rings um jede kristalline Rippe und durch den umgebenden Gate-Isolator davon getrennt.

2. Verfahren nach Anspruch 1, ferner umfassend: Einsenken des umgebenden Gates, sodass das umgebende Gate eine geringere Höhe als eine Höhe jeder kristallinen Rippe hat.

3. Verfahren nach Anspruch 1 oder 2, ferner umfassend: Ausbilden des ersten Source/Drain-Bereichs an einem ersten Ende der kristallinen Rippe und Ausbilden des zweiten Source/Drain-Bereichs an einem zweiten Ende der kristallinen Rippe.

4. Verfahren nach Anspruch 1 oder 2, worin der erste Source/Drain-Bereich unterhalb des zweiten Source/Drain-Bereichs ist und ein Kanalbereich zwischen dem ersten und dem zweiten Source/Drain-Bereich senkrecht ausgerichtet ist.

5. Verfahren nach einem der Ansprüche 1 bis 4, ferner umfassend: Ausbilden mindestens einer Gate-Leitung angrenzend an und in Kontakt mit den umgebenden Gates für mindestens zwei Transistoren.

6. Verfahren nach Anspruch 5, worin das Ausbilden mindestens einer Gate-Leitung einschließt: Ausbilden zweier Gate-Leitungen angrenzend an und in Kontakt mit dem umgebenden Gate, wobei die zwei Gate-Leitungen auf gegenüberliegenden kristallinen Rippen sind.

## Revendications

1. Procédé de formation de transistors, comprenant les étapes consistant à :
former un corps de transistor, comprenant les étapes consistant à :
enlever par gravure, grâce à un procédé lithographique, un trou (613) dans une couche de nitrure de silicium (612) formée sur un substrat de silicium cristallin (615) ;
déposer du silicium amorphe et le graver de manière directionnelle, de manière à ne laisser du silicium amorphe (614) que sur la paroi latérale du trou ;
retirer la couche de nitrure de silicium (612) afin de ne laisser que le silicium amorphe (614) sur le substrat de silicium cristallin ;
mettre en oeuvre un procédé d'épitaxie en phase solide, SPE, afin de cristalliser le silicium amorphe en une paroi de silicium cristallin en utilisant le substrat en silicium cristallin (615) pour amorcer la croissance cristalline,
enlever par gravure des parties de la paroi de silicium cristallin afin de laisser des ailettes cristallines (616) ;
chacun des corps de transistor étant formé dans l'ailette cristalline respective entre une première région de source/drain et une deuxième région de source/drain ;
former un isolant de grille entourante autour de chaque ailette cristalline ; et
former une grille entourante autour, et de manière séparée, de chaque ailette cristalline grâce à l'isolant de grille entourante.

2. Procédé selon la revendication 1, comprenant en outre une étape consistant à renfoncer la grille entourante de telle manière que la grille entourante présente une hauteur inférieure à une hauteur de chaque ailette cristalline.

3. Procédé selon la revendication 1 ou 2, comprenant en outre une étape consistant à former la première région de source/drain au niveau d'une première extrémité de l'ailette cristalline et former la deuxième région de source/drain au niveau d'une deuxième extrémité de chaque ailette cristalline.

4. Procédé selon la revendication 1 ou 2, dans lequel la première région de source/drain se situe en dessous de la deuxième région de source/drain, et une région de canal est orientée de manière verticale entre les première et deuxième régions de source/drain.

5. Procédé selon l'une quelconque des revendications 1 à 4, comprenant en outre une étape consistant à former au moins une ligne de grille adjacente aux grilles entourantes et en contact avec celles-ci pour au moins deux transistors.

6. Procédé selon la revendication 5, dans lequel l'étape de formation d'au moins une ligne de grille comprend une étape consistant à former deux lignes de grille adjacentes à la grille entourante et en contact avec celle-ci, les deux lignes de grille se situant sur des ailettes cristallines opposées.
